# EUROPEAN PATENT APPLICATION

(11) **EP 2 846 159 A1**
(43) Date of publication of application: **11.03.2015**
(21) Application number: 13290212.3
(22) Date of filing: 06.09.2013
(51) Int. Cl.: G01N 29/036, G01N 29/22, H01L 41/22

(54) **Fluid sensor with piezoelectric actuator and process for manufacturing the same**

(71) Applicant: Services Pétroliers Schlumberger, 75007 Paris (FR); SCHLUMBERGER TECHNOLOGY B.V., 2514 JG Den Haag (NL); Schlumberger Holdings Limited, Tortola 1110 (VG)
(72) Inventor: Robutel, Remi, 78990 Elancourt (FR); Hascoet, Stanislas, 92142 Clamart Cedex (FR); Lacroix, Nathalie, 92142 Clamart Cedex (FR)
(74) Representative: Ford, Michael Frederick

(57) **Abstract**

A sensor for measuring a parameter of a fluid includes a housing defining a fluid-proof chamber and an area of reduced thickness defining a membrane separating the chamber from the fluid. An actuating/detecting element is positioned within the chamber and mechanically coupled with the membrane. The actuating/detecting element includes a multilayer structure, having a metallic material member having a first metallized layer, and a piezoelectric material member having a second metallized layer connected to the first metallized layer via a sintered silver joint. A resonating element is mechanically coupled with the membrane and extends from the membrane, the resonating element being sized and dimensioned to transfer mechanical vibrations to and from the actuating/detecting element.

## Description

### BACKGROUND

This disclosure relates to downhole sensors and tools, and more particularly to methods and apparatuses for making downhole sensors and tools.

### Description of the Related Art

Piezoelectric materials generate an internal electrical charge when subjected to pressure. This internal electrical charge may be harnessed by coupling piezoelectric materials with electrodes, and using this unique property in a variety of devices, including ignition devices, acoustic and mechanical sensors, actuators, and transducers, which may be implemented in a variety of consumer devices and/or industrial equipment.

Piezoelectric materials include ceramic materials which have electro-mechanical coupling factors that give relationships between the mechanical stress/displacement applied to the ceramic material and the electric field. Ubiquitous piezoelectric ceramics are based on "PZT" materials, also known as Lead Zirconate Titanates (PbZrTi) including some doping materials to adjust the piezoelectric properties for a particular application. These piezoelectric ceramics are included in the active layer of a variety of devices which convert mechanical vibrations or acoustic waves to an electrical signal, or convert an electrical signal into mechanical vibrations or acoustic waves. During the manufacturing process of piezoelectric ceramic materials, a polarization is implemented by annealing the ceramic material with a strong electric field. The polarization enables the piezoelectric properties of the ceramic material.

If the ceramic piezoelectric material is heated above a temperature specific to that material called the Curie temperature, the polarization is removed and the piezoelectric properties of the ceramic material are lost. The Curie temperatures vary for different types of piezoelectric materials, and generally impose practical limitations on the use of piezoelectric materials in high-temperature environments or applications. As the temperature to which the piezoelectric material is exposed approaches the Curie temperature for that particular material, the performance of the piezoelectric material deteriorates, and repeated cycles of heating and cooling a piezoelectric material to temperatures approaching the Curie temperature greatly reduce the useful life of the piezoelectric material.

Multiple industries use piezoelectric materials in a variety of devices, such as piezoelectric actuators, sensors, or transducers. Typically, layers of piezoelectric materials are bonded or connected with layers of other materials which are heterogeneous with respect to piezoelectric materials (e.g., metallic materials). Typically, the layers of heterogeneous materials are stacked onto one another and are bonded to one another with adhesives, such as resins, or are soldered together via a high-temperature soldering process to manufacture multilayer piezoelectric material structures and devices.

However, adhesives currently used to bond heterogeneous layers of materials typically deteriorate at temperatures lower than the Curie temperatures for most piezoelectric materials. Thus, adhesives are effectively the limiting factor in high-temperature applications of adhesive-bonded piezoelectric devices. Further, the currently used high-temperature soldering process is carried out at temperatures exceeding the Curie temperatures of most piezoelectric materials, thereby requiring that the piezoelectric materials be annealed after the soldering process is complete, which results in a complicated manufacturing process and increased costs and production times of multilayer piezoelectric devices.

The oil and gas industry uses piezoelectric devices for a variety of applications downhole. Piezoelectric density and/or viscosity sensors are used for well sampling and logging applications to decide which zones of a particular well are economical to produce and to install the appropriate infrastructure for that zone. Density and viscosity measurements are also useful to address contamination and downhole fluid analysis in high temperature wells. However, as oilfield operations often require exposing the piezoelectric devices to repeated cycles of high temperatures encountered in oil and gas wells, existing bonding techniques for heterogeneous layers of materials result in relatively short life-cycles of piezoelectric devices used in the oil and gas industry. For instance, the adhesive bonds between the heterogeneous layers of materials rapidly deteriorate as the adhesive bonds are repeatedly exposed to high temperatures.

Another concern with using the soldering process is compliance with the RoHS lead-free standards, as many solders include lead. Recently, studies have been done to implement silver sintering bonding techniques in the electronic manufacturing industry. Silver particle sizes have been investigated. Favorable results are generally obtained with silver particle sizes from 10 µm to 100 nm. However, for Health Safety and Environmental (HSE) purposes, the nanometric particle sizes have not been industrialized yet.

At the same time, the oil and gas industry is looking for high temperature technologies. Piezoelectric actuators and transducers are elements which are sensitive to the harsh operating conditions encountered in the oil and gas industry and in other industries employing high-temperature application of multilayer heterogeneous material devices such as piezoelectric devices.

### SUMMARY

In one aspect, some embodiments of present disclosure are directed to a sensor for measuring a parameter of a fluid. The sensor includes a housing defining a fluid-proof chamber and an area of reduced thickness defining a membrane separating the chamber from the fluid. An actuating/detecting element is positioned within the chamber and is mechanically coupled with the membrane. The actuating/detecting element includes a multilayer structure including a metallic material member having a first metallized layer and a piezoelectric material member having a second metallized layer connected to the first metallized layer via a sintered silver joint. A resonating element is mechanically coupled with the membrane and can be inserted into' the fluid so as to transfer mechanical vibrations between the actuating/detecting element and the fluid. The resonating element extends from the membrane and is sized and dimensioned to transfer mechanical vibrations to and from the actuating/detecting element.

In another aspect, some embodiments of the present disclosure are directed to a downhole tool that can be used for example, to sense at least one property of an environment around the downhole tool in a wellbore, or to transmit/receive acoustic communications using a tubular as a communication medium, for example. The downhole tool includes an actuating element having a multilayer structure including a metallic material member having a metallized layer and a piezoelectric material member having a metallized layer connected to the metallized layer of the metallic material member via a sintered silver joint. The downhole tool also includes a non-transitory processor readable medium, and a control circuit electrically coupled with the actuating element and the non-transitory processor readable medium, the control circuit has at least one of (a) first circuitry to supply an excitation signal to the actuating element so as to cause the actuating element to vibrate; (b) second circuitry to receive a detection signal from the actuating element, the detection signal indicative of vibration of the actuating element and store the detection signal in the non-transitory processor-readable medium.

In a further aspect, some embodiments of the present disclosure are directed to a multilayer structure including a metallic material member having a metallized layer, and a piezoelectric material member having a metallized layer connected to the metallized layer of the metallic material member via a sintered silver joint. The piezoelectric material member generates a voltage in response to receipt of mechanical stress.

In another aspect, some embodiments of the present disclosure are directed to a process of making a multilayer structure of heterogeneous material members. The process includes forming a silver layer onto a metalized layer of a first member, the silver layer including silver particles and a solvent. The process further includes placing a second member onto the first member such that a metalized layer of the second member is in contact with the silver layer to form a multilayer structure. At least one of the first and second members being a piezoelectric material that generates a voltage in response to receipt of mechanical stress, and the first and second members being heterogeneous. The process also includes applying a temperature and pressure cycle to the multilayer structure so that a sintered silver joint is formed by the silver layer diffusing into the metallized layers.

In yet another aspect, some embodiments of the present disclosure are directed to a piezoelectric member, including a piezoelectric material member that generates a voltage upon receipt of mechanical stress, and a metallic material deposited onto the piezoelectric material member so as to form a metallized layer.

### BRIEF DESCRIPTION OF THE DRAWINGS

So that the manner in which the above recited features can be understood in detail, a more particular description may be had by reference to embodiments, some of which are illustrated in the appended drawings, wherein like reference numerals denote like elements. It should be understood, however, that the appended drawings illustrate various embodiments and are therefore not to be considered limiting of its scope, and may admit to other equally effective embodiments.

Figure 1 is a perspective view of a multilayer piezoelectric actuator according to some embodiments of the present disclosure.

Figure 2 is a cross-sectional view of the multilayer piezoelectric actuator of Figure 1.

Figure 3 is an exploded view diagram of the members of the multilayer piezoelectric actuator of Figure 1.

Figure 4 is a diagram showing a metallized coating of a metallic member according to some embodiments of the present disclosure.

Figure 5 is a top plan view showing a layer of silver paste deposited onto an electrode member of a multilayer piezoelectric actuator according to some embodiments of the present disclosure.

Figure 6 is a perspective view of a sintering mold according to some embodiments of the present disclosure.

Figure 7 is a perspective view of a first mold half of the sintering mold of Figure 6.

Figure 8 is a perspective view of a second mold half of the sintering mold of Figure 6.

Figure 9 is a graph showing temperature as a function of time during a sintering process for manufacturing a multilayer piezoelectric actuator according to some embodiments of the present disclosure.

Figure 10 is a diagram of a sintered silver joint between a piezoelectric member and a metallic member according to some embodiments of the present disclosure.

Figure 11 is a cross-sectional view and an enlarged cross-sectional view part schematically showing a sensor for measuring density and viscosity of a fluid according to some embodiments of the present disclosure.

Figure 12 is a schematic illustration of an electronic arrangement associated with the sensor of Figure 11.

While the foregoing is directed to embodiments described herein, other and further embodiments may be devised without departing from the basic scope thereof, and the scope thereof is determined by the claims that follow.

### DETAILED DESCRIPTION

In the following description, numerous details are set forth to provide an understanding of the present disclosure. It will be understood by those skilled in the art, however, that the embodiments of the present disclosure may be practiced without these details and that numerous variations or modifications from the described embodiments may be possible.

In the specification and appended claims: the terms "connect", "connection", "connected", "in connection with", and "connecting" are used to mean "in direct connection with" or "in connection with via one or more elements"; and the term "set" is used to mean "one element" or "more than one element". Further, the terms "couple", "coupling", "coupled", "coupled together", and "coupled with" are used to mean "directly coupled together" or "coupled together via one or more elements". As used herein, the terms "up" and "down", "upper" and "lower", "upwardly" and downwardly", "upstream" and "downstream"; "above" and "below"; and other like terms indicating relative positions above or below a given point or element are used in this description to more clearly describe some embodiments of the disclosure.

Some embodiments of the present disclosure will now be described in detail with reference to the accompanying drawings. Further, in the following detailed description of embodiments of the present disclosure, numerous specific details are set forth in order to provide a more thorough understanding of the disclosure. However, it will be apparent to one of ordinary skill in the art that the embodiments disclosed herein may be practiced without these specific details. In other instances, well-known features have not been described in detail to avoid unnecessarily complicating the description.

The terminology and phraseology used herein is for descriptive purposes and should not be construed as limiting in scope. Language such as "including," "comprising," "having," "containing," or "involving," and variations thereof, is intended to be broad and encompass the subject matter listed thereafter, equivalents, and additional subject matter not recited or inherently present therein.

Unless expressly stated to the contrary, "or" refers to an inclusive or and not to an exclusive or. For example, a condition A or B is satisfied by anyone of the following: A is true (or present) and B.is false (or not present), A is false (or not present) and B is true (or present), and both A and B are true (or present).

In addition, use of the "a" or "an" are employed to describe elements and components of the embodiments herein. This is done merely for convenience and to give a general sense of the inventive concepts. This description should be read to include one or at least one and the singular also includes the plural unless it is obvious that it is meant otherwise.

Further, as used herein any reference to "one embodiment" or "an embodiment" means that a particular element, feature, structure, or characteristic described in connection with the embodiment is included in at least one embodiment. The appearances of the phrase "in one embodiment" in various places in the specification are not necessarily all referring to the same embodiment, although the inventive concepts disclosed herein are intended to encompass any and all combinations and permutations of the features of the embodiments described herein.

As used herein, the term "layer" is intended to include at least one layer, or covering or coating or material formed on another material. Layer includes a single layer or coating, and multiple layers or coatings, as will be appreciated by persons of ordinary skill in the art having the benefit of the instant disclosure.

As used herein the term "heterogeneous" is intended to include two or more members or materials which are different from one another such as metallic and nonmetallic materials, metallic and ceramic materials, piezoelectric materials and non-piezoelectric materials, and thermoelectric and non-thermoelectric materials, and combinations thereof.

Embodiments of the present disclosure are applicable to multilayer heterogeneous stacks or multilayer structures including two or more stacked layers of heterogeneous materials, such as metallic materials and piezoelectric materials, and to methods of manufacturing such multilayer structures. The piezoelectric materials can be made of a ceramic material or a crystalline material that generate a voltage upon receipt of mechanical stress that can be induced by mechanical force or changes in temperature, for example. Some embodiments of the present disclosure are directed to multilayer piezoelectric actuators which can be used in a sensor or a downhole tool, as well as methods of making the multilayer piezoelectric actuator, sensor or a downhole tool.

Some embodiments of the present disclosure include a manufacturing process for bonding layers of heterogeneous materials (e.g., metallic alloys to piezoelectric ceramics, or piezoelectric ceramics to other materials) at low temperatures (e.g., below about 300 °C) based on a low-temperature silver sintering bonding, to form a multilayer structure including several heterogeneous layers. Multilayer piezoelectric devices constructed according to embodiments of the present disclosure may be configured to operate at temperatures from about 150°C or higher, such as about 200 °C and higher.

Broadly stated, surfaces of two heterogeneous materials or components (e.g., a metallic material member and a piezoelectric material member) are plated or coated with a metallized layer including precious metals (e.g., Au, Pd, Ag, or alloys). A silver paste/ink including solvent, silver particles and additives is deposited (e.g., jet-printed) onto a metallized layer of at least one of the heterogeneous material members. The deposited silver paste may be dried so that the solvent substantially evaporates, and the silver particles and/or some additives remain on the metallized layer. Two or more heterogeneous material members may be stacked together so as to position the silver paste between the metallized layers of the members. The silver paste may be sintered by applying a predetermined pressure and temperature profile to the stacked members to bond the members via a sintered silver joint. Applying pressure onto the stacked members facilitates diffusion of the silver particles, which may increase the density of the sintered silver joint, and its mechanical strength and electrical and thermal conductivity.

Embodiments of the present disclosure are applicable to piezoelectric actuators configured to operate at relatively high temperatures. Multilayer piezoelectric actuators according to some embodiments of the present disclosure may be constructed with substantially no adhesives and/or by using a RoHS compliant bonding technique. Further, multilayer piezoelectric actuators according to some embodiments of the present disclosure may be constructed without the use of high temperature soldering techniques, and/or by using commercial and separate parts from the market to make complex multilayer structures. For example, applications of embodiments of the present disclosure may include, but are not limited to detectors (seismic, automotive, military, etc.), low power energy harvesting systems, medical sensors, downhole tools, communication devices, and combinations thereof.

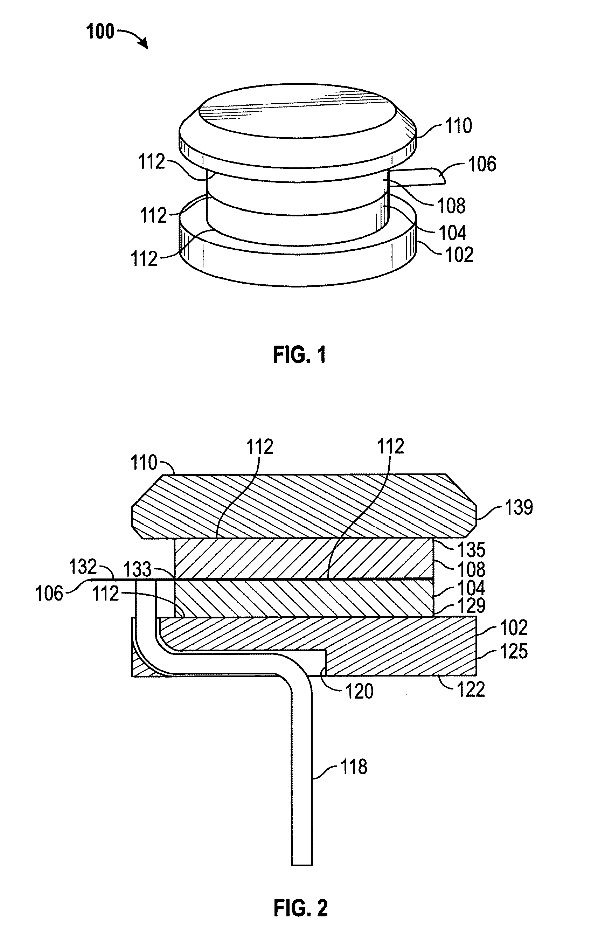

Referring to Figures 1-3, a multilayer piezoelectric actuator 100 according to some embodiments of the present disclosure is a multilayer structure including multiple heterogeneous material members, such as metallic material members and piezoelectric material members. The multilayer piezoelectric actuator 100 includes a first metallic material member 102, a first piezoelectric material member 104, an electrode member 106, a second piezoelectric material member 108, and a second metallic material member 110, bonded together via sintered silver joints 112. An optional wire 118 is shown electrically coupled with the electrode member 106 and extending through an optional slot 120 formed in the first metallic material member 102 adjacent to a surface 122 of the first metallic material member 102. Multilayer piezoelectric actuators 100 according to embodiments of the present disclosure may be used in density-viscosity sensors, in acoustic communication devices, or in any other desired devices.

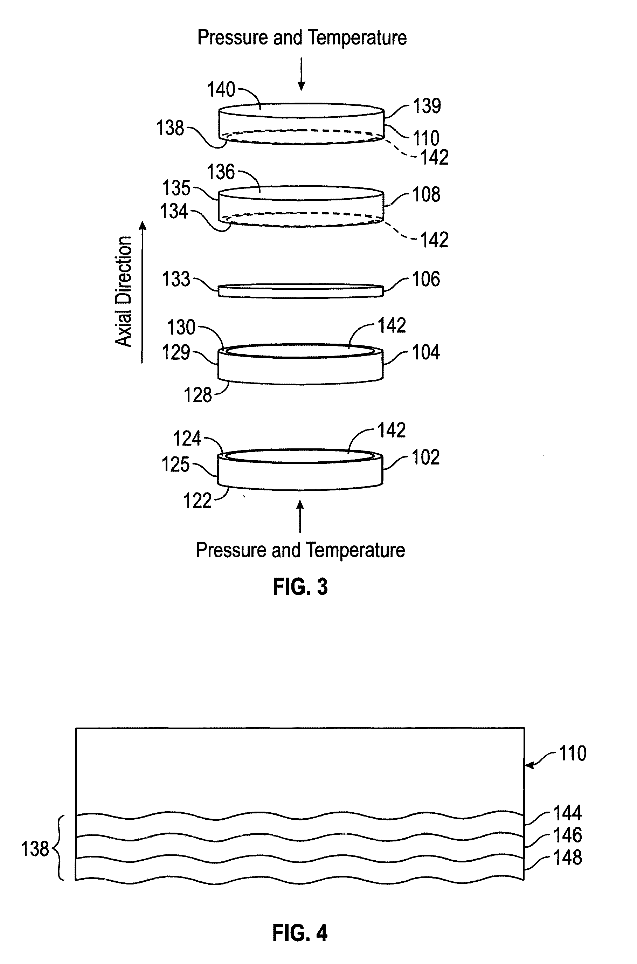

As shown in Figure 3, the first metallic material member 102 may have the surface 122, a metallized layer 124, an edge 125, and the optional slot 120 formed therein. The surface 122 and the metallized layer 124 may be finished via a metallization/plating process that will be described in detail below, to enhance the mechanical, thermal, and/or electrical connection between the members of the multilayer piezoelectric actuator 100 and/or a device into which the multilayer piezoelectric actuator 100 is incorporated. The first metallic material member 102 may be constructed of substantially pure metals (Cu, Al, Fe) and/or of metallic alloys including stainless steels (for instance 316L, Fe: 64-66 %, C: 0.02 %, Cr: 16-18 %, Ni: 11-13 %, Mo: 2 %) or Inconel® alloys (for instance Inconel® 718, Ni: 50-55%, Cr: 17-21 %, Fe: 24.6-13.2, Nb: 4.75-5.5 %, Mo: 2.8-3.3 %, Ti: 0.65-1.15 %, Al: 0.2-0.8 %). The first metallic material member 102 is shown as being substantially cylindrical in shape, but can be implemented with any desired shape, size, or cross-section.

The optional wire 118 may be implemented as a conductive material insulated by an optional layer of insulation, and configured to carry electrical signals to the electrode member 106 and/or away from the electrode member 106, for example. In some embodiments, the wire 118 may be plated with a conductive material to enhance soldering and corrosion resistance and/or may be insulated with one or more layers of insulating material(s). The wire 118 may be electrically coupled with the electrode member 106 in any desired manner, such as, for example, via soldering or adhesives. In some embodiments, the electrical signals may be used to drive the multilayer piezoelectric actuator 100.

The optional slot 120 may be configured so as to allow the optional wire 118 electrically coupled with the electrode member 106 to extend therethrough and past the surface 122 of the first metallic material member 102.

The first metallic material member 102 may serve as a mechanical and/or thermal interface between external mechanical or electrical parts and the multilayer piezoelectric actuator 100. The first metallic material member 102 may function to ensure mechanical forces are substantially distributed onto the first piezoelectric material member 104. In some embodiments, the first metallic material member 102 may act as an outer electrode and may be electrically coupled with an external component and/or with the electrode member 106.

The first piezoelectric material member 104 has a first metallized layer 128, an edge 129, and a second metallized layer 130. The first metallized layer 128 is bonded, joined, connected, or otherwise associated with the metallized layer 124 of the first metallic material member 102 via the sintered silver joint 112.

The first piezoelectric material member 104 may be constructed of any desired material that exhibits piezoelectric properties, such as, for example, Lead Zirconate Titanate (PbZrTi, or PZT). The first piezoelectric material member 104 may have a Curie temperature which is over the highest temperature of the method that will be described below (e.g., about 300°C) and over the maximum operating temperature expected to be encountered by the multilayer piezoelectric actuator 100 (e.g., from about 150°C to about 300°C, or from about 200°C to about 300°C). In some embodiments, the first piezoelectric material member 104 may be constructed of a mechanically active material (e.g., a piezoelectric material) or a thermally active material (e.g., a thermoelectric material).

The first piezoelectric material member 104 may have any desired shape such as square, rectangular, circular, or irregular or complex, depending on the design requirements of the multilayer piezoelectric actuator 100. In some embodiments, the first piezoelectric material member 104 may have a thickness varying from about 100 µm to about 2 mm and a diameter varying from about 1 mm to about 20 mm. The first piezoelectric material member 104 may be manufactured as a bulk piezoelectric material, and may be machined and plated according to the metallization process that will be described below.

The electrode member 106 is connected to the second metallized layer 130 of the first piezoelectric material member 104 via a sintered silver joint 112. The electrode member 106 may be constructed of a conductive material, such as a metallic compound or alloy, or a substantially pure metal (e.g., silver). The electrode member 106 may be implemented as a laminated metallic foil in some embodiments. The electrode member 106 may be an electrical conductor and may be constructed of Cu, Ag, or Au foil. The electrode member 106 may be unplated, or may be plated with single, double, or multilayer metallic material coating as a finish metallization, via a metallizing or plating process that will be described in detail below. Further, the electrode member 106 may be plated with a layer of material (e.g., copper, or other relatively soft material) to adjust the mechanical coupling between the electrode member 106 and the first piezoelectric material member 104 and/or the second piezoelectric material member 108, which layer of material may be plated with a finish metallization via the metallizing process described below. The electrode member 106 may be configured to provide a path for electrical communication from the first and second piezoelectric material members 104 and 108 of the multilayer piezoelectric actuator 100 to the wire 118.

The electrode member 106 is shown as being substantially circular, and may have a diameter varying from about 1 mm to about 20 mm, and a thickness varying from about 1 µm to 250 µm, for example. The electrode member 106 may have an edge 133 and a contact portion 132 extending substantially laterally from the edge 133. The contact portion may be configured to be electrically coupled with the optional wire 118 and may have a width and length varying from about 0.5 mm to about 10 mm. The contact portion132 may extend laterally beyond the edge 129 of the first piezoelectric material member 104 as shown in Figure 2. It is to be understood that the electrode member 106 may have any desired size and may be implemented with any desired shape such as square, rectangular, circular, or even more complicated, depending on the design requirements.

The second piezoelectric material member 108 may be implemented and may function similarly to the first piezoelectric material member 104 and includes a first metallized layer 134, an edge 135, and a second metallized layer 136. The first metallized layer 134 is connected with the electrode member 106 via a sintered silver joint 112, and the second metalized layer 136 is connected with the second metallic material member 110 via a sintered silver joint 112 as will be described below.

The second metallic material member 110 may be implemented and function similarly to the first metallic material member 102, with the exception that the slot 120 may be omitted. The second metallic material member 110 includes a metallized layer 138 connected with the second metalized layer 136 of the second piezoelectric material member 108 via a sintered silver joint 112, an edge 139, and a surface 140. In some embodiments the second metallic material member 110 may be referred to as a thrust washer (e.g., as a part of the chassis in acoustic implementations of the multilayer piezoelectric actuator 100) and may mechanically couple the multilayer piezoelectric actuator 100 with an external component or device, such as via the surface 140. For example, the second metallic material member 110 may ensure that mechanical forces applied to the surface 140 are well distributed through the second piezoelectric material member 108 and the first piezoelectric material member 104. In some embodiments, the second metallic material member 110 may also function as an outer electrode and may electrically couple the multilayer piezoelectric actuator 100 to any desired external component or device (e.g., via the surface 140).

The sintered silver joint 112 may include a silver layer 142, which may include, for example, a paste or ink of silver (Ag) particles (e.g., powder, nanoparticles, or flakes), solvent, one or more optional binders and/or one or more optional additives (e.g., terpineol, N-methyl-2-pyrrolidone, ethylene glycol, dimethyl acetamide or unbranched or branched C5-C9 alcohols, silver carbonate (Ag2CO3), or doping compounds to make a composite material such as SiC) as desired to adjust the viscosity, density, and/or fluidic properties of the silver layer 142. In some embodiments, diamond/aluminum nitride/silicon, or any other desired material with high thermal conductivity and a low coefficient of thermal expansion (CTE), can be used to decrease the CTE of the sintered silver joint 112 and/or to make the CTE of the sintered silver joint 112 similar to the CTE of the first ceramic material member 104 and/or the second ceramic material member 108, for example. The silver layer 142 may be deposited on the metallized layers 124, 130, 134, or 138 and/or onto the electrode member 106 in any desired manner such as by screen-printing or jet-printing or by being dispensed or stamped. The silver particles of the silver layer 142 may have sizes ranging from about 10 nm to about 100 µm. The additives may speed up the sintering process and/or may reduce the sintering temperature of the silver layer 142 and/or may prevent low temperature agglomeration so as to enhance the bonding strength of the sintered silver joint 112 depending on the pressure and temperature applied during the sintering process as will be described below.

Examples of suitable silver pastes for the silver layer 142 include silver pastes commercially available from Hereaus, Henkel, Argomax (Cookson), or NBE Tech. For instance, the mAgic Paste Microbond LTS Series (Low Temperature Sintering) from Hereaus may be used as silver paste. It is noted that particle size, solvent and additives of the silver paste of the silver layer 142 may be adjusted depending on the sintering process to optimize bonding strength of the sintered silver joint 112. A good bond between two heterogeneous material members, such as the first metallic material member 102 and the first piezoelectric material member 104 may result from good adhesion between the sintered silver joint 112 and the respective metallized layers 128 and 130. A good bond between two heterogeneous material members may also result from a good cohesion of the sintered silver joint 112 (e.g., from low porosity and/or substantially homogeneous sintered silver joint 112). The sintering process of using the silver layer 142 to form the sintered silver joint 112 will be described in detail below.

Referring now to Figures 4-6, a method according to some embodiments of the present disclosure may be used to manufacture a multilayer piezoelectric actuator, such as the multilayer piezoelectric actuator 100, or any other desired multilayer structure with two or more layers of heterogeneous materials. As will be appreciated by a person of ordinary skill in the art, the method may be carried out in a clean room (e.g., no excessive ultraviolet, no dust, low humidity, and substantially no chemical pollution) at ambient and controlled atmosphere. Operators may utilize gloves, protection glasses, overshoes, lab coats, or any other desired personal protection or clean room equipment.

Prior to stacking, bonding, or connecting the various members of the multilayer piezoelectric actuator 100, various surfaces of the members may be metallized, coated, or plated to form the metallized layers 124, 128, 130, 134, 136, and 138, for example. The metallization or plating process may provide a degree of freedom for the designer to adapt the silver sintering process according to the inventive concepts disclosed herein to the different materials to be bonded. Lifetime and environmental requirements for the multilayer piezoelectric actuator 100 may also affect the metallization/plating process for the selection of materials and thicknesses of the metallized layers 124, 128, 130, 134, 136, and 138. In some embodiments, a single metallized layer may be formed (e.g., deposited) onto each member to form the metallized layers 124, 128, 130, 134, 136, and 138. In some embodiments, multiple sublayers may be formed onto each member to form the metallized layers 124, 128, 130, 134, 136, and 138.

A single layer may be used to form the metallized layers 124, 128, 130, 134, 136, and 138, and may include one or more metallic materials or alloys such as Ag, Au, or AuPd. The single layer is the first material to react with the sintered silver joint 112. The metallization/plating may also have a preventive function against the oxidation of the underlying member being metallized, especially with Au.

In some embodiments where multiple sublayers are used to form a metallized layer, metallic materials like Cr, Ni, Ti, W, or more complex alloys may be formed onto the member as an optional adhesion sublayer to ensure adherence of the metallized layer to the underlying member. In some embodiments, an optional diffusion barrier sublayer may be formed onto the adhesion sublayer, and may function as a diffusion barrier to limit the diffusion of the silver particles of the silver layer 142 past the diffusion barrier sublayer. The diffusion barrier sublayer may include a diffusion barrier material such as Ni, Pd, Pt, or a more complex alloy. A top sublayer may be implemented similarly to the single layer described above and may be formed onto the adhesion sublayer. The collective thickness of the adhesion sublayer, the diffusion barrier sublayer, and the top sublayer may vary between about 10 nm and 100 µm, depending on the forming method. Average roughness of the top sublayer may be maintained between about 10 nm and about 10 µm (e.g., as measured by a surface profilometer such as the HRP-250 from KLA Tencor, using stylus which is in contact with the surface of the top sublayer).

Deposition methods that may be used to form the top sublayer, the diffusion barrier sublayer, and the adhesion sublayer onto a layer of base material to form the metallized layers 124, 128, 130, 134, 136, and 138 according to the inventive concepts disclosed herein may be varied as desired. The deposition methods may include: Thin film deposition (e.g., thickness up to 10 µm) such as Physical Vapor Deposition (PVD) by sputtering; Chemical Vapor Deposition (CVD) or also known as Plasma Assisted Chemical Vapor Deposition (PACVD) or Plasma Enhanced Chemical Vapor Deposition (PECVD); Thick film deposition (e.g., thickness over 10 µm), such as electroplating, or screen-printing. Other suitable methods may include electroless plating, immersion plating, and cold spray deposition methods, as will be appreciated by persons of ordinary skill in the art having the benefit of the instant disclosure.

Referring now to Figure 4, one embodiment of a metallized layer 138 of the second metallic material member 110 is shown. The metallized layer 138 is about 5 µm thick and can include an optional Ti adhesion sublayer 144 formed onto the second metallic material member 110 (e.g., Inconel® 718). An optional diffusion barrier sublayer 146 is shown formed onto the adhesion sublayer 144. A metallized top sublayer 148 is formed onto the optional diffusion barrier sublayer 146 and may be a silver sublayer formed by PVD. As will be understood by persons of ordinary skill in the art having the benefit of the present disclosure, the diffusional barrier sublayer 146 and/or the adhesion sublayer 144 may be omitted in some embodiments of the inventive concepts disclosed herein, and the metallized top sublayer 148 may be formed onto the second metallic material member 110, as a single metallized layer 138.

The metallized layers 124, 128, 130, 134, 136, and 138 may be cleaned with mild cleaners such as acetone or ethanol, and highly chemically aggressive cleaning agents that are used to clean electronic boards (e.g., solvents and/or degreasers, such as JELT degreasers) are desirably avoided to prevent damaging the metallized layers 124, 128, 130, 134, 136, and 138 and/or to prevent increasing the average roughness of the metallized layers 124, 128, 130, 134, 136, and 138 and/or to avoid interactions between the cleaning agents used and any remaining residues of the solvents or additives of the silver layer 142. The members with the finished metallized layers 124, 128, 130, 134, 136, and 138 may be stored properly (e.g., under primary vacuum) after the metallization process to prevent contamination and/or excessive oxidation.

In some embodiments, the first piezoelectric material member 104 and the second piezoelectric material member 108 may be provided by the manufacturer of the piezoelectric material with pre-formed metallized layers (e.g., including silver screen-printed metallized layers which may function as the metallized layers 128 and 134 and/or the metallized layers 130 and 136). For example, an electrode paste containing silver particles, additives (e.g., glass fibers), and organic solvents may be deposited by the manufacturer of the piezoelectric material to form the metallized layers 128 and/or 130 of the first piezoelectric material member 104 and/or the second piezoelectric material member 108 by screen-printing. After drying, the electrode paste may be heated at a relatively high temperature (over about 700 °C). The thickness of the deposited silver layer may be from about 1 µm to about 50 µm, and an average roughness of the silver layer may vary from about 0.1 µm to about 10 µm. This method may be carried out by the manufacturer of the piezoelectric material prior to annealing the piezoelectric material to give it piezoelectric properties.

To form the sintered silver joint 112, a silver layer 142 may be deposited on the metallized layers 124, 128, 130, 134, 136, and 138 of the members (e.g., the first metallic material member 102, the first piezoelectric material member 104, the second piezoelectric material member 108, and the second metallic material member 110). For instance, referring back to Figure 3 , the first metallic material member 102 and the first and second piezoelectric material members 104 and 108 may have a silver layer 142 deposited on their respective metallized layers 130 and 134.

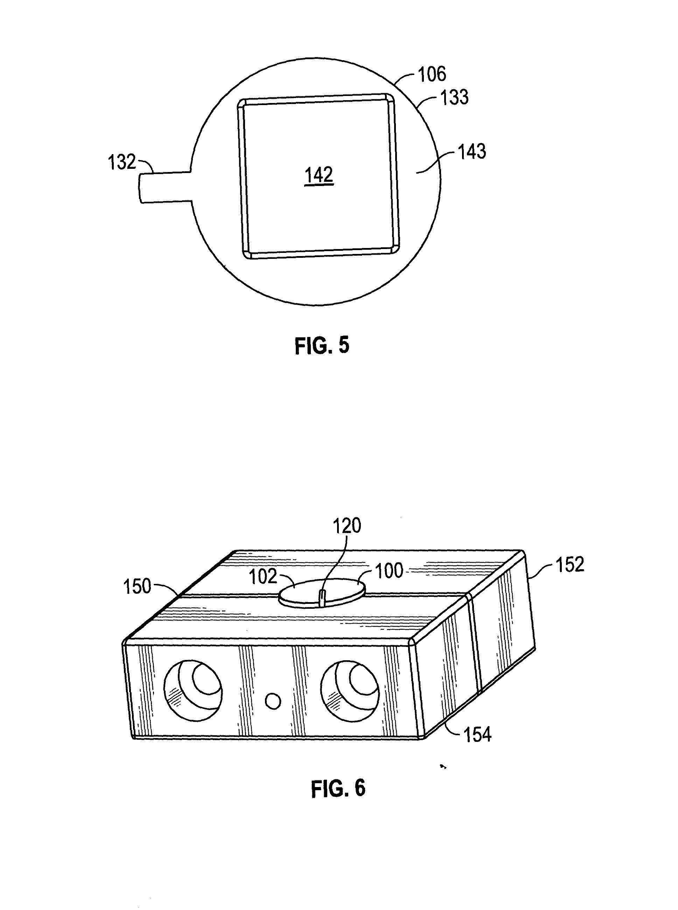

Referring now to Figure 5, in one embodiment, the silver layer 142 may be screen-printed or jet-printed or dispensed or stamped onto the electrode member 106 using a suitable stencil. The silver layer 142 may have a thickness varying from about 10 µm to about 250 µm, and any desired printed shape such as square, rectangular, circular, or even more complicated, depending on the design requirements. In some embodiments, the silver layer 142 may have a shape which may be the same as the electrode member 106 to ensure mechanical forces are well-distributed onto the members bonded by the sintered silver joint 112 during the sintering process. A border area 143 may be designed to ensure the silver paste or the silver ink of the silver layer 142 does not go over the edge 133 of the electrode member 106 so as to avoid the creation of an electrically conductive path (short-circuit) between two bonded members (e.g., 106 and 104 and/or 106 and 108). The size of the border area 143 may depend on the viscosity of the silver paste and on the mechanical tolerances of the screen-printing instruments used to deposit the silver layer 142 onto the electrode member 106. It is to be understood that while the silver layer 142 is shown as being substantially square in Figure 5, the silver layer 142 may have any desired shape (e.g., circular as shown in Figure 3). Further, in some embodiments of the present disclosure, the silver layer 142 may have a shape matching the shape of the respective members of the multilayer piezoelectric actuator 100 which are to be boned by a sintered silver joint 112.

The silver layers 142 may be dried to substantially evaporate the solvents and/or additives from the silver layers 142. The drying may be done at atmospheric pressure in air atmosphere in some embodiments. Drying temperatures may vary from ambient temperature (e.g., about 23 °C, or from about 18 °C to about 25 °C) to about 150 °C. Drying times may vary from about 10 seconds to about 30 min depending on the silver paste, the thickness of the deposited silver layer 142, and the drying temperatures. The process may be optimized by using a Thermo-Gravimetric Analysis (TGA) to determine the loss of mass with the time and the temperature. A proper drying is considered to be achieved when no more loss of mass is observed with a TGA, which indicates that the solvent has evaporated or substantially evaporated from the silver layer 142. To prevent any reliability and cracking issues into the sintered silver joint 112 due to overstress, the heating rate may be maintained to be equal or lower than about 10 °C/min. The members of the multilayer piezoelectric actuator 100 may not be stacked during the drying in order to minimize the risk of starting the sintering process during the drying. Not stacking the members may speed up the drying process and may make the members easier to handle and assemble together.

It is to be understood that in some embodiments, drying may be carried out as a part of the sintering process, and the solvent and/or additives may be substantially evaporated from the silver layer 142 by using a relatively slow heating ramp to reach the desired sintering temperature as described below, so that sintering does not start until the solvent and/or additives have been substantially evaporated from the silver layer 142, for example.

For instance, in some embodiments, the viscosity of the silver paste used to form the silver layer 142 may be selected to be relatively high such that it is possible to stack the members 102, 104, 106, 108, and 110 together before drying. For example, a preformed silver layer 142 having a relatively high density and including silver powder (and/or one or more binders, solvents, or additives) may be applied to the various members as described above, so as to allow stacking the members 102, 104, 106, 108, and 110 together in the mold 150, and/or to allow omitting drying and substantially evaporating the binder, solvent, and/or additives by using a relatively slow heating ramp to reach the desired sintering temperature.

If the members were not stacked during the drying process, the various members of the multilayer piezoelectric actuator 100 may be stacked onto one another once the drying process is completed. The members may be positioned onto one another so that the silver layers 142 are positioned between the metallized layers of adjacently disposed members. The stacked members may be positioned so as to be substantially centered relative to one another such that the edges 129, 133, and 135 are coaxially aligned and such that the edges 125 and 139 are coaxially aligned. The various members are positioned so that the mechanical stress (pressure) is well distributed through the multilayer piezoelectric actuator 100 in the axial direction. This alignment also ensures that the multilayer piezoelectric actuator 100 has a good reliability (e.g., minimizing risk of cracks under harsh operating conditions and reducing the chances of poor electro-mechanical coupling due to misalignment of the members.

Figure 3 shows the ordering of the members of the multilayer piezoelectric actuator 100 according to some embodiments of the present disclosure. To maintain the members mechanically aligned during the sintering process, a mold 150 as shown in Figures 6-8 may be used. Other desired devices or apparatus may be implemented to mechanically hold the members together during the sintering process. The mold 150 that may be used to make the multilayer piezoelectric actuator 100 according to embodiments of the present disclosure is designed to mechanically maintain the desired coaxial alignment of the members (e.g., 102, 014, 106, 108, and 110) during the sintering process. The mold 150 may have any desired tolerance, such as tolerance equal or lower than about 50 µm to ensure optimal alignment of the members in the mold 150, such that the edges 129, 133, and 135 are substantially coextensive with one another, and such that the edges 125 and 139 are substantially coaxially aligned with one another.

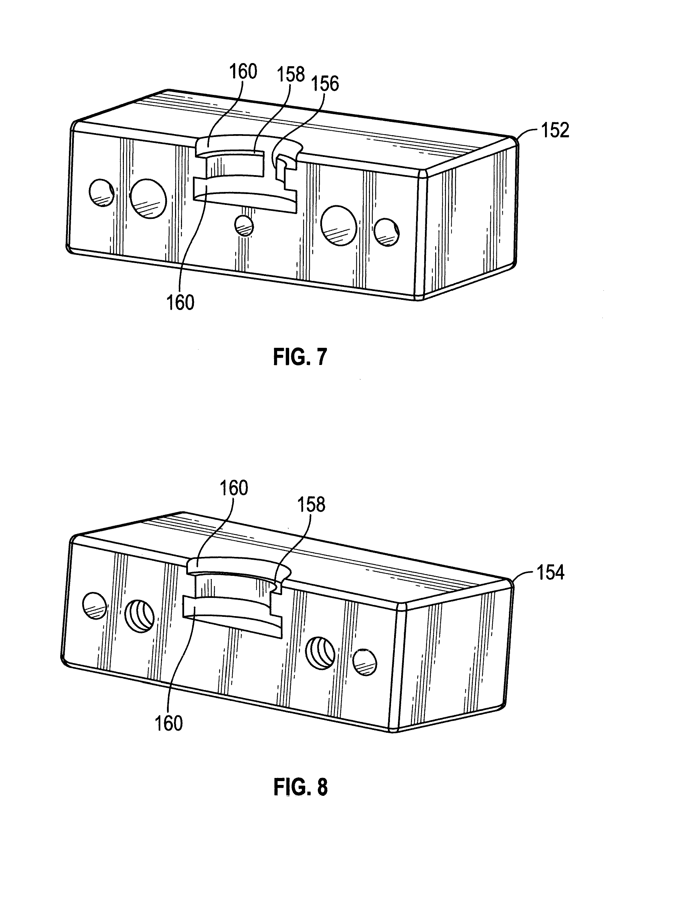

As shown in Figure 6, the members may be positioned onto one another in the mold 150 so that the multilayer piezoelectric actuator 100 is positioned in the mold 150 upside down. In this manner, the first metallic material member 102 is protruding slightly above the mold 150 so as to allow for the application of pressure onto the members of the multilayer piezoelectric actuator 100. The mold 150 may include two mold halves 152 and 154 as shown in Figures 7-8, which may be attached to one another to lock the various members of the multilayer piezoelectric actuator 100 in any desired manner, such as, for example, via bolts, screws, brackets, clamps, and combinations thereof. The mold half 152 may include a notch 156 formed therein and configured to receive the contact portion 132 of the electrode member 106 therein. The mold halves 152 and 154 may further include shoulders 158 formed therein, the shoulders 158 being configured to maintain the coaxial alignment of the edges 129, 133, and 135 of the first piezoelectric material member 104, the electrode member 106, and the second piezoelectric material member 108, respectively, during the sintering process. The mold halves 152 and 154 may also include a pair of recesses 160 formed therein, the pairs of recesses 160 configured to maintain the coaxial alignment of the edges 125 and 139 of the first metallic material member 102 and the second metallic material member 110 during the sintering process.

In some embodiments, the electrode member 106 may be electrically coupled with the mold 150 so as to avoid charge accumulation generated by the pressure of the sintering process and to reduce internal stress into the first piezoelectric material member 104 and the second piezoelectric material member 108 which reduces the risk of cracks and depolarization of the piezoelectric material. As will be appreciated by persons of ordinary skill in the art, pressure applied to the first piezoelectric material member 104 and the second piezoelectric material member 108 during the sintering process according to the present disclosure may create a temporary polarization that is the opposite of the permanent polarization of the first piezoelectric material member 104 and the second piezoelectric material member 108 created during manufacturing of the piezoelectric material, which may result in electrical current being generated in the electrode member 106.

The mold 150 may be configured to have good thermal conductivity so as to minimize the thermal capacity and maximize the thermal conductivity throughout the mold 150 so as to ensure low discrepancies between temperatures required for an optimized sintering and the actual temperatures at the sintered silver joints 112. The mold 150 may be configured to withstand the repetitive pressure and temperature cycles of the sintering process according to embodiments of the present disclosure. The mold 150 can be constructed of any desirable materials such as aluminum or steel, for example. While the mold 150 is shown as holding stacked members 102, 104, 106, 108, and 110 of one multilayer piezoelectric actuator 100, a mold 150 according to embodiments of the present disclosure may be configured to hold the stacked members 102, 104, 106, 108, and 110 of two or more, or multiple multilayer piezoelectric actuator 100 (e.g., in large-scale production).

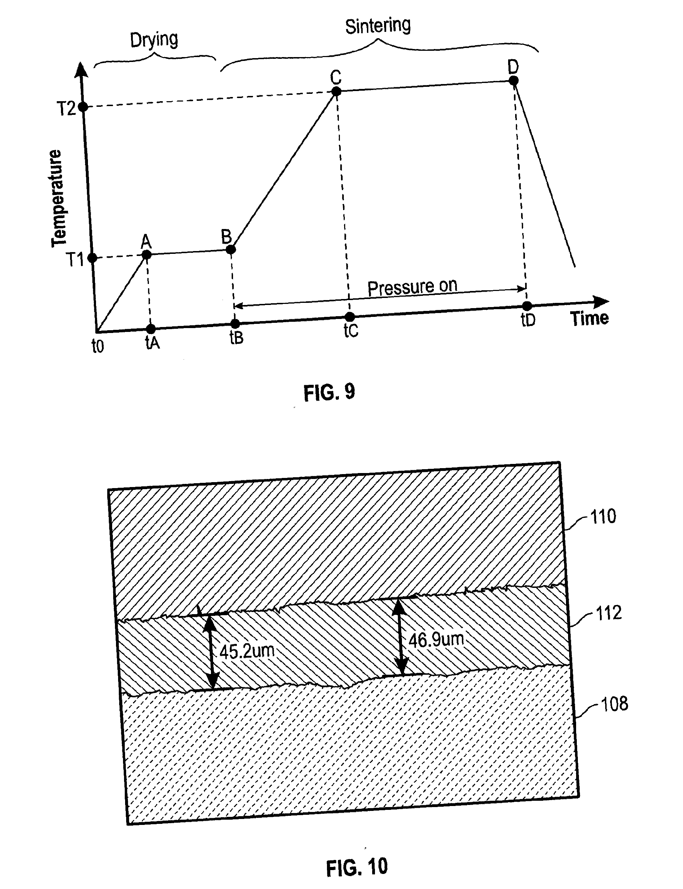

Referring now to Figure 9, the stacked members 102, 104, 106, 108, and 110 are subjected to a pressure and temperature cycle (an example of which is shown in Figure 9) in a given atmosphere to trigger a diffusion mechanism of the silver layer 142 at low temperature due to the small silver particle size and the pressure to which the stacked members are subjected. The silver particles of the silver layer 142 may diffuse into the metallized layers 124, 128, 130, 134, 136, and 138 of the members 102, 104, 106, 108, and 110. The sintering process according to the present disclosure decreases the porosity of the silver joint 112 to make a dense silver layer that is highly stable at temperatures of up to about 300 °C. The sintering atmosphere may be air, vacuum, or inert gas. For low pressure sintering (e.g., equal or lower than 5 MPa), air atmosphere may be used because of the presence of oxygen.

T1 in Figure 9 is defined as the drying temperature, and T2 is the sintering temperature. t0 is the initial time, and t0 to tA is the warm-up time to reach T1. The heat rate between t0 and tA is between about 1°C/min and about 10°C/min. From tA to tB, the drying temperature is kept substantially constant for a time varying between about 10 seconds and about 30 minutes. The tolerance on temperature control during the time between tA to tB may be ±1°C. After reaching the operating conditions described by point B, the members of the multilayer piezoelectric actuator 100 may be mechanically aligned and positioned into the mold 150 as described above (e.g., where the drying is carried out prior to placing the members of the multilayer piezoelectric actuator 100 onto one another). In some embodiments, the members of the multilayer piezoelectric actuator 100 may be mechanically aligned and positioned into the mold 150 prior to t0 or prior to point B (e.g., where the drying is carried out as part of the sintering process). The transition between alignment and positioning and sintering may be automated into the same atmosphere (into the same temperature conditioner). It is also possible to interrupt the cycle at the point B, to manually align and position the members of the multilayer piezoelectric actuator 100.

From tB to tC, sintering starts with the warm-up until the sintering temperature is reached: The heat rate between tB and tC may be from about 2°C/min to about 20°C/min. From tC to tD, the sintering temperature is kept substantially constant from about 200 °C to about 300 °C for a period varying from about 1 minute to about 60 minutes, such as from about 5 minutes to about 30 minutes, about 5 minutes to about 60 minutes, or any other period of time as determined by the amount of pressure applied to the stacked members 102, 104, 106, 108, and 110. For example, increasing the pressure applied to the stacked members 102, 104, 106, 108, and 110 may shorten the period of time (e:g., below about 30 minutes, or below about 5 minutes), and decreasing the pressure applied to the stacked members 102, 104, 106, 108, and 110 may increase the period of time (e.g., beyond about 30 minutes, or beyond about 60 minutes), as will be recognized by a person of ordinary skill in the art having the benefit of the instant disclosure. It is to be understood that in some embodiments, the sintering process may be performed with substantially no pressure being applied to the stacked members 102, 104, 106, 108, and 110, in which case the temperature cycle and/or the composition of the silver layer 142 may be adjusted accordingly. The tolerance on temperature control at steady state may be about ±1°C.

From tB to tD, the pressure is applied onto the members along the axial direction. Pressure may range from about 1 MPa to about 40 MPa, depending on the silver paste, temperature profile and the members to be bonded. Tolerance on pressure control at steady state may be lower than about ±10 % of the nominal value. After reaching the operating condition described by the point D, sintering stops. Pressure is released gradually and the temperature is lowered down to ambient temperature (e.g., about 23°C or from about 18 °C to about 25 °C) at a rate equal to or lower than about 10°C/min. After the pressure and temperature cycle, the members are bonded via the silver joints 112 and the assembly of the multilayer piezoelectric actuator 100 is substantially complete.

The multilayer piezoelectric actuator 100 may be removed from the mold 150 (e.g., by separating the mold halves 152 and 154) and may be cleaned and/or incorporated in another device. A wire, such as the wire 118 may be electrically coupled with the electrode member 106 and/or may be positioned in the slot 120. Careful handling prevents damage the contact portion 132 of the electrode member 106. The surfaces 140 and 122 of the second metallic material member 110 and the first metallic material member 102 are protected to ensure good electrical and/or mechanical contact with external mechanical parts.

Optionally, the multilayer piezoelectric actuator 100 may be cleaned after unmolding to avoid unexpected failure and to allow a proper storage of the multilayer piezoelectric actuator 100. Cleaning removes impurities or pollution that may induce short-circuits or may accelerate the degradation while operating the multilayer piezoelectric actuator 100 into a system or device. Mild cleaning agents such as acetone or ethanol may be used to avoid damaging or excessively increasing the average surface roughness of the cleaned surfaces. The multilayer piezoelectric actuator 100 may be stored while the system or device into which the multilayer piezoelectric actuator 100 is to be incorporated is manufactured. Storage may be in a clean room under primary vacuum in a hermetic package or dedicated conditioner, for example.

Referring now to Figure 10, shown therein is a diagram of the sintered silver joint 112 between the second metallic material member 110 and the second piezoelectric material member 108 after applying a sintering temperature and pressure cycle as described above. The sintered silver joint 112 had a thickness of about 50 µm and is dense with low porosity. The silver particles from the silver layer 142 have diffused through the metallized layers 136 and 138 of the second piezoelectric material member 108 and the second metallic material member 110.

The shear strength of sintered silver joint bonded members according to embodiments of the present disclosure is presented in Table 1 below after applying a sintering temperature and pressure cycle at different interfaces: washer (Inconel® 718/piezoelectric ceramic (PZT), washer (Inox 316L)/piezoelectric ceramic (PZT), and piezoelectric part (PZT)/inner electrode (Ag foil)/piezoelectric part (PZT). As Table 1 shows, high and reproducible shear strength may be achieved with a sintered silver joint according to the inventive concepts disclosed herein.

**Table 1**

| Assembly | Sample # | Force (kg) | Shear strength (Mpa) |
|---|---|---|---|
| PZT/Inconel | 1 | 56,18 | 34,44 |
| | 2 | 56,76 | 34,8 |
| | 3 | 81,49 | 49,96 |
| PZT/Inox | 4 | 54,1 | 33,17 |
| | 5 | 50,47 | 30,94 |
| | 6 | 51,98 | 31,87 |
| PZT/Ag Foil/PZT | 8 | 48,33 | 24,15 |
| | 9 | 95,35 | 47,66 |

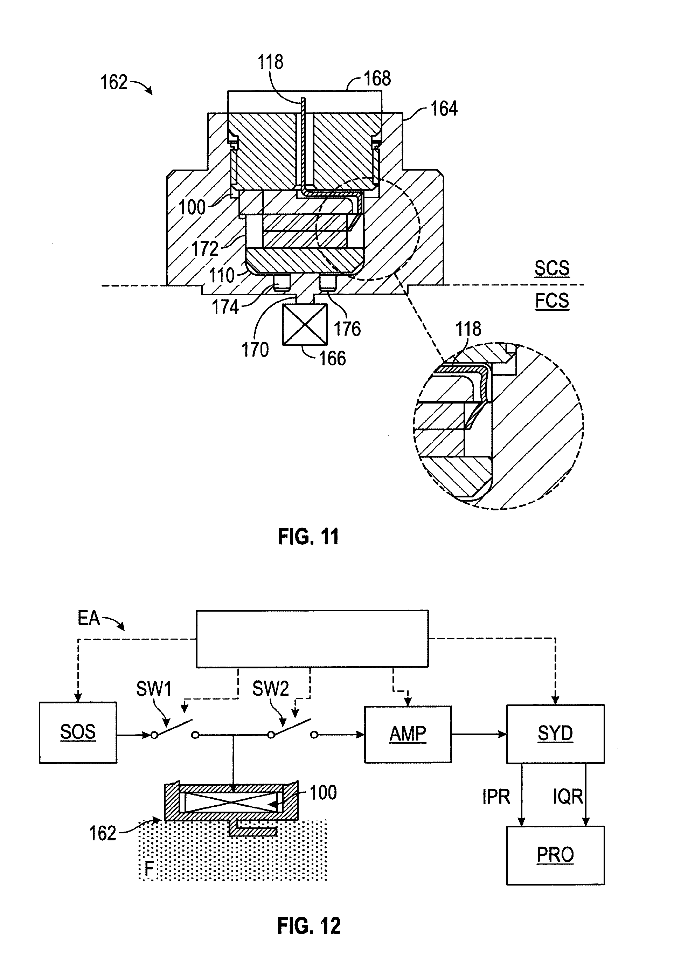

Referring now to Figure 11 a cross-section view of a sensor 162 is shown therein. As will be appreciated by a person of ordinary skill in the art, in some embodiments of the present disclosure, the sensor 162 may be implemented as any one of the sensors described in U.S. Patent No. 7,874,199, the entire disclosure of which is expressly incorporated herein by reference.

For clarity purpose, Figure 11 also shows a magnified portion of a piezoelectric element connection area.

The sensor 162 includes a housing 164 and a resonating element 166 and is configured to detect a parameter of a fluid (e.g., density and/or viscosity). The fluid can be one or more gases, one or more liquids and combinations thereof. In Figure 11, the resonating element 166 which may have various shapes, is symbolized by a crossed rectangle.

The housing 164 may include a connector 168 which may be implemented as a standardized coax connector, a multi-socket connector or any other connector configured for a particular application. The housing 164 may also have an optional peripheral groove (not shown) for receiving an O-ring type seal (not shown) or any other suitable seal configured to separate a fluid contacting side FCS from a sensor connecting side SCS.

In some embodiments, a mechanical coupling element 170 may be formed as an integral part with the housing 164. However, it will be apparent for a person skilled in the art that the mechanical coupling element 170 may be formed as an integral part with the resonating element 166 or may be an additional part coupled with the housing 164 and with the resonating element 166. The mechanical coupling element 170 may mechanically couple the housing 164 with the resonating element 166 so that vibrations can be transmitted into the housing 164 via the resonating element 166. Another function of the mechanical coupling element 170 is to position the resonating element 166 into a fluid to be measured, so that the resonating element 166 is surrounded by the fluid or totally immersed in the fluid. The resonating element 166 and the housing 164 may be integral or not with the mechanical coupling element 170 and may be assembled together (e.g., by any appropriate technique such as welding, gluing, or brazing).

The housing 164 may define a chamber 172 and a cavity 174. The cavity 174 defines an area where the housing 164 has a reduced thickness defining a membrane 176 between the cavity 174 and the fluid contacting side FCS. The mechanical coupling element 170 is positioned onto the membrane 176. In some embodiments, the mechanical coupling element 170 may be positioned at substantially a center point on the membrane 176. The chamber 172 may be filled with a vibration absorbing material (e.g., gas, oil, gel, etc.), which may reduce parasitic vibration modes of the housing 164.

A multilayer piezoelectric actuator 100 may be positioned in the cavity 172 and/or the chamber 174 and may function as an actuating/detecting element. The multilayer piezoelectric actuator 100 may be coupled with the housing 164 via the mechanical coupling element 170.

For example, the mechanical coupling element 170 may contact the second metallic material member 110 of the multilayer piezoelectric actuator 100. The membrane 176 is configured to allow efficient transmission of mechanical signal(s) between the resonating element 166 and the multilayer piezoelectric actuator 100 while ensuring hermetically separating the fluid contacting side FCS from the cavity 172. The first metallic material member 102 may be positioned against the connector 168 and the wire 118 may be electrically coupled with the connector 168 such that one or more electrical signals may be received from or transmitted to the multilayer piezoelectric actuator 100 via the connector 168.

In some embodiments of the present disclosure, the sensor 162 may include any desired features for securing the sensor 162 to a conduit, a tube or a pipe, e.g., flange, screw connection, or combinations thereof (not shown in the Figures). Such attachment features may enable optimally positioning the resonating element 166 within the fluid flow of any desired fluid the viscosity or other properties of which are to be tested or measured.

Figure 12 schematically illustrates an example of a downhole tool including an electronic arrangement EA associated with the sensor 162 of Figure 11 and configured to measure a parameter (e.g., density and/or viscosity) of a fluid. The electronic arrangement EA may form an integral part with the sensor 162 by integration inside the cavity 172, or may be externally coupled to an external connector such as the connector 168. The electronic arrangement EA may include discrete electronic components (e.g., one or more processors and/or one or more non-transitory processor readable medium) or may be implemented as an integrated circuit.

The electronic arrangement EA may include a control circuit LOG, and at least one of (a) first circuitry to supply an excitation signal to the actuating element so as to cause the actuating element to vibrate; and (b) second circuitry to receive a detection signal from the multilayer piezoelectric actuator 100, the detection signal indicative of vibration of the multilayer piezoelectric actuator 100, the second circuitry storing the detection signal in the non-transitory processor-readable medium. The first circuitry may include an oscillator SOS and a first switch SW. The second circuitry may include a second switch SW2, an amplifier AMP, a detection circuit SYD and a processing circuit PRO.

The control circuit LOG may be coupled to the oscillator SOS, the first SW1 and second SW2 switch, the amplifier AMP and the detection circuit SYD.

The electronic arrangement EA may by electrically coupled with connector 168 and/or the wire 118 and is configured to perform a sensor excitation and detection method that will be described in more details below.

The control circuit LOG enables the oscillator SOS to supply the excitation signal by closing the first switch SW1 and opening the second switch SW2 at a first instant of time. Thus, the oscillator SOS applies an excitation signal to the multilayer piezoelectric actuator 100. The excitation signal application causes the multilayer piezoelectric actuator 100 to apply displacements (e.g., mechanical vibration) to the mechanical coupling element 170 and to the resonating element 166. The excitation signal may be in the range of a few to a few hundred Volts depending of the excitation signals required, for example.

Once the resonating element 166 has been put into vibration by exciting the multilayer piezoelectric actuator 100, the excitation could be removed and a reception signal representative of the vibration of the resonating element 166 in the fluid F can be measured.

Accordingly, the control circuit LOG enables the second circuitry to receive the detection signal at a second instant of time by closing the second switch SW2 and opening the first switch SW1. Thus, the multilayer piezoelectric actuator 100 generates the detection signal representative of the resonating element 166 vibration. The detection signal may optionally be amplified by the amplifier AMP. The detection signal may be stored in non-transitory processor-readable medium and/or may be transmitted off-site. In some embodiments, the detection signal may be further processed by the downhole tool.

In some embodiments, the detection circuit SYD may perform a synchronous detection during a detection phase. The detection circuit SYD may provide to the processing circuit PRO an actual in-phase response signal IPR and an actual quadrature response signal IQR measured by the multilayer piezoelectric actuator 100. The processing circuit PRO may determine, calculate, or otherwise provides the density and viscosity of the fluid F according to any desired density and viscosity determination method. In some embodiments of the present disclosure, the density and viscosity determination method described in U.S. Patent No. 7,874,199 may be implemented. The density and viscosity method may be carried out by the electronic arrangement EA of the downhole tool.

In some embodiments, a downhole tool according to the present disclosure may be implemented as an actuator, and may include an actuating element, which may be implemented as the multilayer piezoelectric actuator 100. The actuating element may include a resonating element, such as the resonating element 166, which may be mechanically coupled with the multilayer piezoelectric actuator 100 and extends from the multilayer piezoelectric actuator 100. The resonating element 166 is sized and dimensioned to transport mechanical vibrations of one or more predetermined frequencies to and from the multilayer piezoelectric actuator 100. A control circuit, such as the control circuit LOG may be electrically coupled with the actuating element and may function to supply an excitation signal to the actuating element so as to cause the actuating element to apply mechanical vibrations to the resonating element. In some embodiments, the control circuit may also receive a detection signal indicative of the vibration of the resonating element from the actuating element, and may store the detection signal in a non-transitory computer readable medium.

Although a few embodiments of the present disclosure have been described in detail above, those of ordinary skill in the art will readily appreciate that many modifications are possible without materially departing from the teachings of the present disclosure. Accordingly, such modifications are intended to be included within the scope of the present disclosure as defined in the claims.

Although the preceding description has been described herein with reference to particular means, materials and embodiments, it is not intended to be limited to the particulars disclosed herein; rather, it extends to all functionally equivalent structures, methods, and uses, such as are within the scope of the appended claims.

## Claims

1. A sensor for measuring a parameter of a fluid, the sensor comprising:
a housing defining a fluid-proof chamber and an area of reduced thickness defining a membrane;
an actuating/detecting element positioned within the chamber and mechanically coupled with the membrane, the actuating/detecting element including a multilayer structure, comprising at least one metallic material member having a first metallized layer, and at least one piezoelectric material member having a second metallized layer connected to the first metallized layer via a sintered silver joint; and
a resonating element mechanically coupled with the membrane and extending from the membrane, the resonating element sized and dimensioned to transfer mechanical vibrations to and from the actuating/detecting element.

2. A downhole tool, comprising:
an actuating element including a multilayer structure including at least one metallic material member having a first metallized layer and at least one piezoelectric material member having a second metallized layer connected to the first metallized layer via a sintered silver joint;
a non-transitory processor readable medium; and
a control circuit electrically coupled with the actuating element and the non-transitory processor readable medium and having at least one of:
(a) first circuitry to supply an excitation signal to the actuating element so as to cause the actuating element to vibrate; and
(b) second circuitry to receive a detection signal from the actuating element, the detection signal indicative of vibration of the actuating element, the second circuitry storing the detection signal in the non-transitory processor readable medium.

3. The downhole tool of claim 2, further comprising:
a resonating element mechanically coupled with the actuating element and extending from the actuating element, the resonating element sized and dimensioned to transport mechanical vibrations of one or more predetermined frequencies to and from the actuating element.

4. The downhole tool of claim 3, wherein the control circuit enables the first circuitry to supply the excitation signal to the actuating element at a first instant of time, and enables the second circuitry to receive the detection signal at a second instant of time.

5. A multilayer structure, comprising:
at least one metallic material member having a first metallized layer; and
at least one piezoelectric materials member that generates a voltage upon receipt of mechanical stress, the at least one piezoelectric material member having a second metallized layer connected to the first metallized layer via a sintered silver joint.

6. The multilayer structure of claim 5, wherein the at least one piezoelectric material member includes a third metallized layer, and wherein the multilayer structure further comprises an electrode member connected with the third metallized layer via a second sintered silver joint.

7. The multilayer structure of claim 6, further comprising:
a second piezoelectric material member having a fourth metallized layer connected to the electrode via a third sintered silver joint, wherein the second piezoelectric material member includes a fifth metallized layer, and wherein the structure further comprises a second metallic material member having a sixth metallized layer connected to the fifth metalized layer via a fourth sintered silver joint.

8. The multilayer structure of claim 5, wherein the first metallized layer comprises:
an adhesion sublayer formed onto the metallic material member;
a silver diffusion barrier sublayer formed onto the adhesion sublayer and configured to limit diffusion of silver particles therethrough; and
a metallized sublayer formed on the silver diffusion barrier sublayer.

9. A process of making a multilayer structure of heterogeneous material members, comprising:
forming a silver layer onto a first metalized layer of a first member, the silver layer comprising silver particles and a solvent;
placing a second member onto the first member such that a second metalized layer of the second member is in contact with the silver layer and the first and second members form a multilayer structure, at least one of the first member and the second member being a piezoelectric material that generates a voltage in response to receipt of mechanical stress, and the first member and the second member being heterogeneous; and
applying a temperature and pressure cycle to the multilayer structure so that a sintered silver joint is formed by the silver layer at least partially diffusing into the first metallized layer and the second metallized layer.

10. The process of claim 9, wherein the temperature and pressure cycle comprises:
heating the multilayer structure to a temperature from about 200° C to about 300° C at a rate between about 2°C per minute and about 20°C per minute;
maintaining the multilayer structure at a relatively constant temperature varying from about 200°C to about 300°C for a period of time from about 5 minutes to about 30 minutes;
applying an axial pressure from about 1 Mpa to about 40 Mpa to the multilayer structure;
releasing the axial pressure from the multilayer structure; and
cooling the multilayer structure to ambient temperature at a rate equal to or lower than about 10°C per minute.

11. The process of claim 9, further comprising:
forming at least one metallized layer onto the first member so as to form the first metallized layer of the first member; and
drying the silver layer so that the solvent substantially evaporates, wherein drying the silver layer comprises:
heating the silver layer to a temperature from about 18°C to about 150°C at a rate from about 1°C per minute to about 10°C per minute; and
maintaining the silver layer at a temperature from about 18°C to about 150° C for a period of time of at least 10 seconds.

12. The process of claim 9, wherein the first member is the piezoelectric material, and wherein the piezoelectric material is constructed of at least one of a mechanically active material and a thermally active material.

13. The process of claim 9, wherein the first member is a non-metallic material member and the second member is a metallic material member.

14. A piezoelectric member, comprising:
a piezoelectric material member that generates a voltage upon receipt of mechanical stress; and
a metallic material deposited onto the piezoelectric material member so as to form a metallized layer.

15. The piezoelectric member of claim 14, wherein the metallized layer comprises an adherence sublayer formed onto the piezoelectric material member and a top sublayer formed on the adherence sublayer.
